# EUROPEAN PATENT APPLICATION

(11) **EP 1 675 179 A1**
(43) Date of publication of application: **28.06.2006**
(21) Application number: 05027679.9
(22) Date of filing: 16.12.2005
(51) Int. Cl.: H01L 25/065, H01L 23/552

(54) **Stacked-type semiconductor device**

(30) Priority: 27.12.2004 JP 2004376996
(71) Applicant: SHINKO ELECTRIC INDUSTRIES CO., LTD., Nagano-shi, Nagano 381-2287 (JP)
(72) Inventor: Kei, Murayama, Nagano-shi Nagano 381-2287 (JP)
(74) Representative: Schmidt, Steffen J.

(57) **Abstract**

A stacked-type semiconductor device including a plurality of semiconductor elements stacked through a spacer is disclosed. The electrical characteristics with the bonding wires are improved and a narrow pitch is secured. The stacked-type semiconductor device includes a lower semiconductor element (2) fixed on a wiring board (1), an insulating spacer (4) fixed on the lower semiconductor element (2), a grounded spacer (10) fixed on the insulating spacer (4) and having a grounding conductor film formed on a part or the whole of the upper surface thereof, an upper semiconductor element (5) fixed on the grounded spacer (10), bonding wires (3, 6, 12) for electrically connecting between the lower semiconductor element (2) and the wiring board (1), between the upper semiconductor element (5) and the wiring board (1) and between the grounding conductor film of the grounded spacer (10) and the grounding terminal of the wiring board (1), respectively, and a seal resin (7) for sealing the bonding wires.

## Description

### BACKGROUND OF THE INVENTION

### 1. Field of the Invention

This invention relates to a stacked-type semiconductor device comprising a plurality of semiconductor elements in a stacked structure or, in particular, to a technique for advantageously improving the reliability of the stacked-type semiconductor device by preventing the deterioration of the electric characteristics thereof which otherwise might be caused by a lengthened bonding wire connecting the semiconductor elements.

### 2. Description of the Related Art

In the prior art, a semiconductor device comprising a plurality of semiconductor elements stacked on a wiring board is called a stacked-type semiconductor device. A stacked-type semiconductor device is a composite form of semiconductor device in which a plurality of semiconductor elements, such as a control chip and a memory chip, are stacked on a wiring board to provide different functions or to secure an increased memory capacity.

The stacked-type semiconductor device finds suitable applications as an electronic part of compact, high-density electronic devices and optical devices such as the mobile phones and the digital cameras.

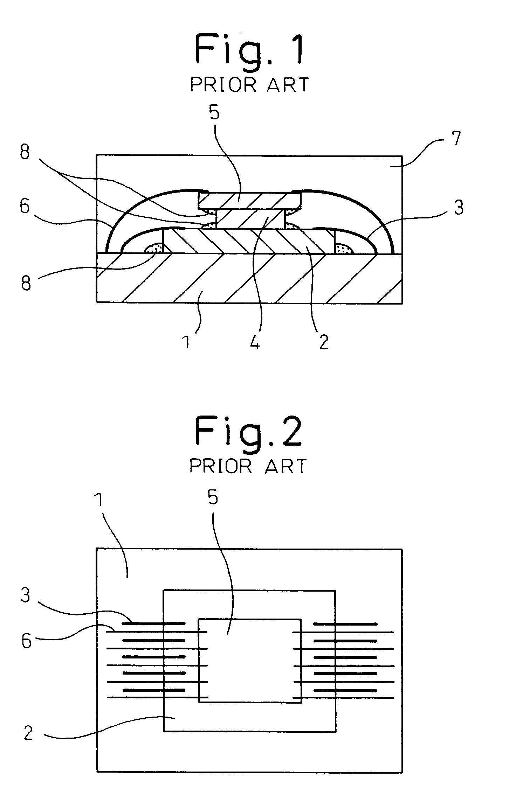

Figs. 1 and 2 show the conventional stacked-type semiconductor device. A lower semiconductor element 2 is mounted on the upper surface of a wiring board 1, and the lower semiconductor element 2 and the wiring board 1 are electrically connected to each other by bonding wires 3. A spacer 4 is arranged on the upper surface of the lower semiconductor element 2, and an upper semiconductor element 5 is mounted on the spacer 3. The upper semiconductor element 5 and the wiring board 1 are electrically connected to each other as required by bonding wires 6, after which the semiconductor elements 2 and 5, the spacer 4, the bonding wires 3 and 6, and etc. are sealed by a molding resin thereby to complete a stacked-type semiconductor device.

As a conventional technique related to the invention, Japanese Unexamined Patent Publication No. (JP-A) 2002-217354 discloses a stacked-type semiconductor device which uses a wiring relay member to reduce the risk of electrical shorting between the bonding wires.

Specifically, in the stacked-type semiconductor device disclosed in JP-A 2002-217354, a lower semiconductor element is fixed on a wiring board, a wiring relay member is fixed on the lower semiconductor element, and an upper semiconductor element is fixed on the wiring relay member. The wiring board and the lower semiconductor element are connected to each other by first bonding wires, and the upper semiconductor element and the wiring relay member are connected to each other by second bonding wires. Further, the wiring relay member and the wiring board are connected to each other by third bonding wires. The first to third bonding wires are sealed with resin.

As another conventional technique, Japanese Unexamined Patent Publication No. (JP-A) 2004-158747 discloses a stacked-type semiconductor device and a fabrication method wherein a plurality of semiconductor elements are stacked and sealed in a single semiconductor package, and wherein at least one semiconductor element is connected to another semiconductor element and the exterior of the semiconductor package by wire bonding using gold wires. In this conventional technique, all the functional surfaces of the semiconductor elements connected by the gold wires, except for the input/output terminals and the wire bonding interference area thereof, are formed with a spacer having a height larger than the top of the gold wire loop.

As described above, in the conventional stacked-type semiconductor devices shown in Figs. 1 and 2 or disclosed the prior art documents, such as JP-A 2002-217354 or JP-A 2004-158747, the risk of electrical shorting between the semiconductor elements and/or the complicated bonding wires is avoided by the interposition of a spacer or a wire relay member between a plurality of the semiconductor elements in stack.

In the conventional stacked-type semiconductor device shown in Figs. 1 and 2 or disclosed in JP-A 2002-217354 or JP-A 2004-158747, however, although the arrangement of a spacer or a wire relay member between the semiconductor elements alleviates the risk of electrical shorting due to the entangled bonding wires, the bonding wires for connecting the semiconductor elements are lengthened and the wire arrangement for connecting the required bonding wires to the grounding connection terminals is complicated while, at the same it is difficult to improve the electrical characteristics of the bonding wires.

### SUMMARY OF THE INVENTION

Accordingly, it is an object of this invention to provide a stacked-type semiconductor device comprising a plurality of semiconductor elements stacked with a spacer interposed between the semiconductor elements, wherein the electrical characteristics involving the bonding wires can be improved and a narrow pitch can be realized.

In order to achieve this object, according to this invention, there is provided a stacked-type semiconductor device comprising a wiring board, a lower semiconductor element fixed on the wiring board, an insulating spacer fixed on the lower semiconductor element, a grounded spacer fixed on the insulating spacer and having a grounding conductor film on the whole or a part of at least the upper surface thereof, an upper semiconductor element fixed on the grounded spacer, first bonding wires for electrically connecting the lower semiconductor element and the wiring board to each other, second bonding wires for electrically connecting the upper semiconductor element and the wiring board to each other, third bonding wires for electrically connecting the grounding conductor film of the grounded spacer and the grounding terminal of the wiring board to each other, and a sealing resin for sealing the first to third bonding wires.

In the stacked-type semiconductor device according to this invention, as described above, the grounded spacer as well as the spacer are interposed between a plurality of the semiconductor elements stacked on the wiring board, and the grounding conductor film of the grounded spacer and the grounding terminal of the wiring board are electrically connected to each other by the third bonding wires. Therefore, a gap is secured by the spacer between the lower semiconductor element and the upper semiconductor element thereby to secure a space for arrangement of the bonding wires. At the same time, the number of the second bonding wires for electrically connecting the upper semiconductor element and the wiring board at the bottom of the semiconductor device can be reduced. Thus, the length of the bonding wires can be reduced as a whole. Also, the risk of shorting between the bonding wires is alleviated while, at the same time, improving the electrical characteristics including the connection of the bonding wires.

The grounded spacer includes a plurality of metal surfaces isolated from each other on the surface of an insulating plate. These metal surfaces include a power supply conductor pattern in addition to the grounding conductor film. The power terminal of the upper semiconductor element and the power supply conductor pattern of the grounded spacer are electrically connected to each other by fourth bonding wires, while the power supply conductor pattern of the grounded spacer and the power terminal of the wiring board are electrically connected to each other by fifth bonding wires.

The fact that the power terminal of the upper semiconductor element and the power supply conductor pattern of the grounded spacer are electrically connected to each other by the fourth bonding wires, while the power supply conductor pattern of the grounded spacer and the power terminal of the wiring board are electrically connected to each other by the fifth bonding wire, as described above, can reduce the number of the second bonding wires so that the total length of the bonding wires can be further reduced, thereby contributing to improved electrical characteristics.

The grounded spacer further includes a signal conductor pattern, and the signal terminal of the upper semiconductor element and the signal conductor pattern of the grounded spacer are electrically connected to each other by sixth bonding wires. Further, the signal conductor pattern of the grounded spacer and the signal terminal of the wiring board are electrically connected to each other by seventh bonding wires.

The electrical connection between the signal terminal of the upper semiconductor and the signal conductor pattern of the grounded spacer by the sixth bonding wires and between the signal conductor pattern of the grounded spacer and the signal terminal of the wiring board by the seventh bonding wires, as in the above-mentioned case, can further reduce the number of the second bonding wires, and the length of the bonding wires, thereby improving the electrical characteristics.

Further, the grounded spacer includes a tabular member of a ceramic material formed with a metal conductor film.

### BRIEF DESCRIPTION OF THE DRAWINGS

Figs. 1 and 2 are a sectional view and a plan view, respectively, of the conventional stacked-type semiconductor device;
Figs. 3 and 4 are a sectional view and a plan view, respectively, of a stacked-type semiconductor device according to a first embodiment of the present invention; and
Figs. 5 and 6 are a sectional view and a plan view, respectively, of a stacked-type semiconductor device according to a second embodiment of the present invention.

### DESCRIPTION OF THE PREFERRED EMBODIMENTS

Embodiments of the invention are described in detail below with reference to the accompanying drawings.

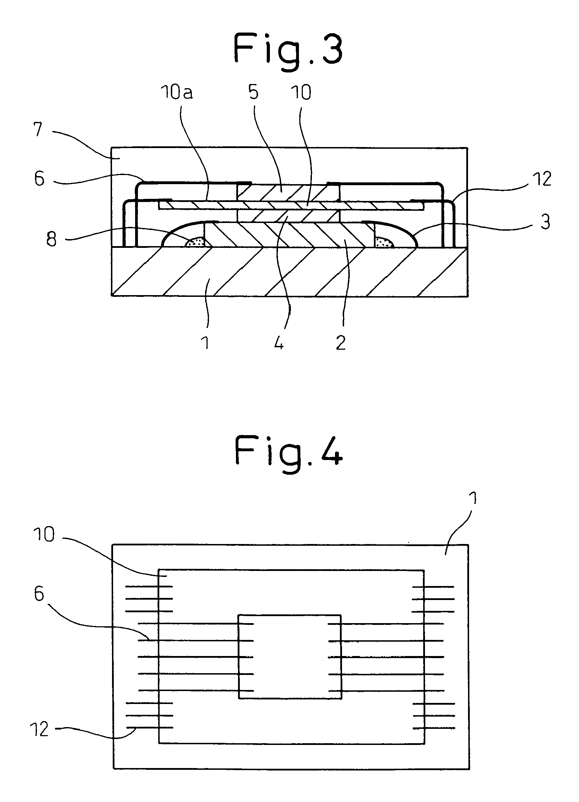

Figs. 3 and 4 show a stacked-type semiconductor device according to a first embodiment of the invention. A lower semiconductor element 2 is fixed on an element mounting area of the upper surface of a wiring board 1 using, for example, an adhesive 8, and the lower semiconductor element 2 and the wiring board 1 are electrically connected to each other by bonding wires 3 as required.

The signal electrode and the terminals of the lower semiconductor device 2 are arranged mainly in the surrounding area of the upper surface of the semiconductor element 2, and a spacer 4 of an insulating material such as ceramics is fixed in the central area of the upper surface of the semiconductor element 2 to secure a gap for the loop of the bonding wire 3, etc. The spacer 4 is a rectangular tabular member having an area smaller than the planar area of the lower semiconductor element 2 and has such a thickness that the parts mounted on the spacer 4 do not interfere with the loop of the bonding wire 3.

A tabular grounded spacer 10 is fixed on the spacer 4. The grounded spacer 10 is such that a grounding conductor surface is formed on the surface of a tabular member formed of an insulating material such as a ceramic. According to this first embodiment, a grounding conductor surface 10a is formed over the whole upper surface of the grounded spacer 10.

An upper semiconductor element 5 is fixed on the upper surface of the grounded spacer 10. On the reverse surface of the semiconductor element 5, a grounding connector is formed, and the semiconductor element 5 is mounted on the grounded spacer 10 using a conductive adhesive (not shown). At the same time, the semiconductor element 5 is electrically connected to the grounding conductor surface 10a on the grounded spacer 10 thereby to secure the grounding of the semiconductor element 5.

The signal electrode terminals, etc. of the upper semiconductor element 5 are electrically connected to the signal pad terminals, etc. of the wiring board 1 by bonding wires 6 as required. Also, the grounding conductor surface 10a on the upper surface of the grounded spacer 10 and the grounding terminals of the wiring board 1 are electrically connected to each other by bonding wires 12 thereby to secure the grounding. In this case, the bonding wires 12 can be connected to the portion of the wiring board 1 just under the edge of the grounding conductor surface 10a and therefore can be comparatively short.

After that, the semiconductor elements 2 and 5, the spacer 4, the grounded spacer 10 and the bonding wires 3, 6 and 12 are integrally sealed by a mold resin 7 thereby to complete a stacked-type semiconductor device according to the first embodiment.

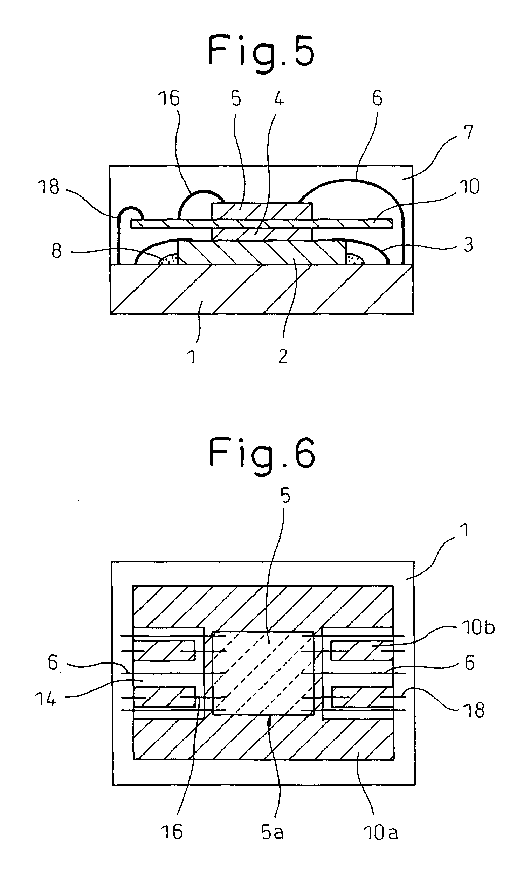

Figs. 5 and 6 shows a stacked-type semiconductor device according to a second embodiment of the invention. Only the points different from the first embodiment are explained. Unlike in the first embodiment wherein the grounding conductor surface 10 is formed over the entire upper surface of the grounded spacer 10, the second embodiment is such that a plurality of metal conductor films are formed on the upper surface of the grounded spacer 10.

Specifically, in the plan view of Fig. 6, the grounding conductor surface 10a is formed in a major part (hatched) of the upper surface of the grounded spacer 10 including the mounting area 5a of the upper semiconductor element 5, and there is an area 14 on each side of the mounting area 5a of the upper semiconductor element 5 where no conductor is formed. In these areas, as many signal conductor patterns 10b as required are formed.

The signal electrode of the upper semiconductor element 5 fixed on the upper surface of the grounded spacer 10 and the signal conductor patterns 10b of the grounded spacer 10 are electrically connected to each other by bonding wires 16. Further, the signal conductor patterns 10b of the grounded spacer 10 and the signal terminal of the wiring board 1 are electrically connected to each other by bonding wires 18 thereby to secure a signal line connecting circuit. In this case, each bonding wire 16 is connected between the signal electrode formed around the upper semiconductor element 5 and the signal conductor patterns 10b of the grounded spacer 10 just under the signal electrode. Each bonding wire 16 thus can connect the edge of the signal conductor patterns 10b of the grounded spacer 10 and the signal terminal of the wiring board 1 just under the particular edge and, therefore, the bonding wires can be comparatively short.

The power electrode or the other signal electrode of the upper semiconductor element 5, like in the first embodiment, is electrically connected directly to the circuit board 1 through the bonding wires 6 from the upper semiconductor element 5.

These semiconductor elements 2 and 5, the spacer 4, the grounded spacer 10 and the bonding wires 3, 6, 12, 16 and 18 are integrally sealed by a mold resin 7 as in the stacked-type semiconductor device according to the first embodiment.

According to the second embodiment, the signal conductor patterns 10b are formed, in addition to the grounding conductor film 10a, on the upper surface of the grounded spacer 10, and connected electrically to the signal electrode of the upper semiconductor element 5 through the conductor patterns 10b. In place of or in addition to the signal conductor patterns 10b, however, a power conductor pattern may be formed on the upper surface of the grounded spacer 10 and, through this conductor pattern, the electrical connection may be established with the power terminal of the upper semiconductor element 5.

The embodiments of the invention are explained above with reference to the accompanying drawings. This invention is not limited to these embodiments, however, and can be variously formed, modified or altered without departing from the spirit and scope thereof.

It will thus be understood from the foregoing description that according to this invention, there is provided a stacked-type semiconductor device, wherein a grounded spacer, as well as a spacer, is interposed between a plurality of semiconductor elements stacked on a wiring board, and the grounding conductor surface of the grounded spacer and the grounding terminal of the wiring board are electrically connected to each other by dedicated bonding wires. Thus, not only is a gap secured by the spacer between the lower semiconductor element and the upper semiconductor element thereby to secure a space for the bonding wire arrangement but, also, the length of the bonding wires as a whole is reduced. As a result, the risk of shorting between the bonding wires is alleviated, while at the same time improving the electrical characteristics of the stacked-type semiconductor device.

## Claims

1. A stacked-type semiconductor device comprising:
a wiring board;
a lower semiconductor element fixed on the wiring board;
an insulating spacer fixed on the lower semiconductor element;
a grounded spacer fixed on the insulating spacer and having a grounding conductor film formed on a part or the whole of at least the upper surface thereof;
an upper semiconductor element fixed on the grounded spacer;
first bonding wires for electrically connecting the lower semiconductor element and the wiring board to each other;
second bonding wires for electrically connecting the upper semiconductor element and the wiring board to each other;
third bonding wires for electrically connecting the grounding conductor film of the grounded spacer and the grounding terminal of the wiring board to each other; and
a seal resin for sealing the first to third bonding wires.

2. A stacked-type semiconductor device according to claim 1,
wherein the grounded spacer is such that a plurality of metal films separated from each other are formed on the surface of an insulating plate and include a power conductor pattern in addition to the grounding conductor film;
wherein the power terminal of the upper semiconductor element and the power conductor pattern of the grounded spacer are electrically connected to each other by fourth bonding wires; and
wherein the power conductor pattern of the grounded spacer and the power terminal of the wiring board are electrically connected to each other by fifth bonding wires.

3. A stacked-type semiconductor device according to claim 1,
wherein the grounded spacer further includes a signal conductor pattern;
wherein the signal terminal of the upper semiconductor element and the signal conductor pattern of the grounded spacer are electrically connected to each other by sixth bonding wires; and
wherein the signal conductor pattern of the grounded spacer and the signal terminal of the wiring board are electrically connected to each other by seventh bonding wires.

4. A stacked-type semiconductor device according to claim 1,
wherein the grounded spacer is a tabular member formed of a ceramic material with a metal conductor film formed thereon.
